# EUROPÄISCHE PATENTSCHRIFT

(11) **EP 0 303 050 B1**
(45) Veröffentlichungstag und Bekanntmachung des Hinweises auf die Patenterteilung: **23.06.1993**
(21) Anmeldenummer: 88110886.4
(22) Anmeldetag: 07.07.1988
(51) Int. Cl.: H01L 21/308, H01L 21/76, H01L 21/82

(54) **Verfahren zum Herstellen von durch Isolationsgräben getrennten Wannen für CMOS-Transistor-Schaltungen**
Process for producing wells for CMOS-transistor circuits separated by isolation trenches
Procédé pour fabriquer des caissons séparés par des tranchées isolantes pour des circuits composés de transistors CMOS

(30) Priorität: 04.08.1987 DE 3725839
(43) Veröffentlichungstag der Anmeldung: 15.02.1989
(73) Patentinhaber: SIEMENS AKTIENGESELLSCHAFT, 80333 München (DE)
(72) Erfinder: Mazure-Espejo, Carlos-Albert, Dr., D-8011 Kirchseeon (DE); Neppl, Franz, Dr., D-8000 München 90 (DE); Zeller, Christoph, Dr., D-8012 Ottobrunn (DE)

(56) Entgegenhaltungen:
- GB-A- 2 081 187
- US-A- 4 331 708
- US-A- 4 546 538
- INTERNATIONAL ELECTRON DEVICES MEETING, 13.-15. Dezember 1982, San Francisco, CA, Seiten 706-709, IEEE, New York, US; L.C. PARRILLO et al.: "Twin-tub CMOS II-an advanced VLSI technology"
- Idem
- PATENT ABSTRACTS OF JAPAN, Band 10, Nr. 228 (E-426), 8. August 1986; & JP-A-61 63 020

## Beschreibung

Die Erfindung betrifft ein Verfahren zum Herstellen benachbarter, mit Dotierstoffen unterschiedlichen Leitungstyps implantierter Wannen, wie sie für die Aufnahme der p-bzw. n-Kanal- oder Bipolartransistoren in hochintegrierten CMOS-Schaltungen verwendet werden, bei dem die Wannen in einem gemeinsamen Halbleitersubstrat angeordnet und durch in das Substrat eingebrachte Isolationsgräben getrennt sind.

Bei einer weiteren Miniaturisierung von CMOS-Bauelementen in ULSI-Technik (ultra large scale integration) kann eine ausreichende Latch-up-Festigkeit nicht mehr mit einer herkömmlichen LOCOS-Isolation erzielt werden. Die Isolationsringe um die Wannen müssen durch das Ätzen und Auffüllen von tiefen und schmalen Gräben hergestellt werden. Andererseits sollen die Isolationsstege innerhalb der Wannen weiterhin flach bleiben, um eine gute elektrische Kontaktierung der Gesamtwanne bei minimaler Wannenkontaktdichte sicherzustellen. Es sind deshalb in dieser Technik zwei getrennte Isolationsprozesse notwendig. Durch den zusätzlichen Photomaskenschritt für die Grabenätzung wird der Prozeß aufwendiger. Die Justiertoleranzen beschränken außerdem die Miniaturisierung.

Um die zusätzliche Phototechnik einzusparen, wurde in einem Bericht von S. Sujama et. al. im IEEE Transactions on Electron Devices, Vol. ED-33, Nr. 11, November 1986, auf den Seiten 1672 bis 1677 vorgeschlagen, die Wannenmaske zu verwenden, um in Lift-off-Technik eine selbstjustierende Aluminium-Maske für die Grabenätzung herzustellen. Nachteile dieses Verfahrens sind die Verspannungen des Siliziumsubstrats durch die Aluminium-Maske, die Metallverunreinigung durch Verwendung von Aluminium in diesem frühen Prozeßstadium und das Auftreten einer hohen Partikeldichte durch den Aluminium-Lift-off. Außerdem erlaubt dieser Prozeß nur eine Wannenimplantation. Ein selbstjustierender Doppelwannenprozeß ist damit nicht möglich.

Aus GB-A-2 081 187 ist ein Verfahren bekannt zur Herstellung eines isolierenden Bereiches mit geringer Breite in einer integrierten Halbleiterstruktur. Insbesondere soll der isolierende Bereich schmaler sein, als es der Auflösungsgrenze der verwendeten Photolithographie entspricht. Dazu wird auf einem Substrat eine erste Maskenschicht und darauf eine zweite Maskenschicht erzeugt. Es wird die erste Maskenschicht unter der zweiten Maskenschicht rückgeätzt. Der rückgeätzte Bereich wird im wesentlichen aufgefüllt. Anschließend wird eine dritte Maskenschicht erzeugt, die auf dem Substrat angeordnet ist in einem Bereich, der vorher weder von der ersten Maskenschicht noch von dem rückgeätzten Bereich bedeckt war. Nach Entfernen der zweiten Maskenschicht und des maskierenden Materials innerhalb des rückgeätzten Bereiches wird ein Graben in das Substrat geätzt unter Verwendung der ersten und der dritten maskierenden Schicht als Ätzmaske. Der Graben wird mit isolierendem Material aufgefüllt.

Aus US-A-4 546 538 ist ein Herstellverfahren für integrierte Halbleiterschaltungsanordnungen bekannt, mit dem es möglich ist, gleichzeitig einen schmalen tiefen Isolationsbereich und einen breiten dicken Feldisolationsbereich herzustellen. Das Verfahren ermöglicht die Herstellung einer ebenen Oberfläche ohne Vogelschnäbel oder Vogelköpfe und soll von kritischen Maskenjustierungsschritten unabhängig sein. Dabei werden in einem Halbleiterschichtaufbau, der ein p⁻-dotiertes Substrat, das mit einer n⁺-dotierten Epitaxieschicht und einer n⁻-dotierten Epitaxieschicht versehen ist, umfaßt, tiefe Gräben hergestellt. Bereiche des Halbleiterschichtaufbaus, in denen Bipolartransistoren hergestellt werden sollen, bleiben bei dem Ätzverfahren von einer SiO₂ und Si₃N₄ enthaltenden Schicht bedeckt. Die übrigen Bereiche des Halbleiterschichtaufbaus, in denen die Oberfläche der n⁻-dotierten Epitaxieschicht freigelegt ist, werden durch thermische Oxidation zu großen Isolationsbereichen oxidiert. Die Gräben werden mit isolierendem Material gefüllt.

Aus Patent abstracts of Japan, Band 10, Nr. 228 (E-426), JP-A-6 163 020 ist bekannt, eine dünne Schicht aus SiO₂ durch Zersetzung von TEOS herzustellen, wobei das Substrat, auf dem die Schicht hergestellt wird, mit Hilfe von Laserstrahlung beleuchtet wird. Dadurch werden Geschwindigkeit und Effektivität der Abscheidung verbessert.

Aus L.C. Parillo et al., IEDM 1980, S. 752 - 755 ist ein Doppelwannenprozeß bekannt, bei dem die erste Wanne unter Verwendung einer ersten Implantationsmaske implantiert wird. Die erste Implantationsmaske besteht aus SiO₂ und Si₃N₄. Durch Aufoxidation der freiliegenden Oberfläche oberhalb der ersten Implantationswanne wird selbstjustiert zur ersten Implantationsmaske eine zweite Implantationsmaske hergestellt, mit deren Hilfe die zweite Wanne implantiert wird. Bei der Aufoxidation der freiliegenden Oberfläche im Grenzbereich zwischen beiden Wannen entsteht dabei eine erhebliche Stufe an der Oberfläche des Substrats. Diese Stufenbildung ist nachteilig, da sie zu Fokusproblemen bei weiteren Prozeßschritten führt.

Aufgabe der Erfindung ist es, ein Verfahren für einen Doppelwannen-CMOS-Prozeß anzugeben, bei dem beide Wannenimplantationen und die Ätzung des Isolationsgrabens mit nur einer Photolacktechnik ausgeführt werden kann. Dabei sollen nur die in der Prozeßtechnik allgemein üblichen Abscheide-, Ätz- und Hochtemperatur-Prozesse zur Anwendung gelangen. Das Verfahren soll sowohl für einen n-Wannenprozeß als auch für einen p-Wannenprozeß geeignet sein. Darüberhinaus soll das Verfahren sicherstellen, daß die Oberfläche der Struktur nach Bildung der beiden Wannen und des Isolationsgrabens im wesentlichen eben und stufenfrei ist.

Diese Aufgabe wird erfindungsgemäß gelöst durch ein Verfahren nach Anspruch 1.

Dabei liegt es im Rahmen der Erfindung, daß die Grabentiefätzung vor der Implantation der zweiten Wanne durchgeführt wird. Zur Vermeidung von Stufenbildungen im Substrat bei der Maskierung der ersten Wanne zur Implantation der zweiten Wanne wird eine Hilfsschicht aus polykristallinem Silizium verwendet, die vor der zu unterätzenden Siliziumoxidschicht ganzflächig auf die Substratoberfläche aufgebracht wird und bis zur Grabenätzung auf der Oberfläche verbleibt.

Gemäß einem Ausführungsbeispiel nach der Lehre der Erfindung wird nach der anisotropen Grabenätzung eine thermische Oxidation durchgeführt, bei der auch die in die Wannen implantierten Dotierstoffionen eindiffundiert werden.

Weitere Ausgestaltungen der Erfindung ergeben sich aus den Unteransprüchen.

Die Gräben werden nach der Entfernung der Oxidmaske mit thermischem Oxid und Polysilizium ausgefüllt. Das thermische Oxid dient gleichzeitig als Diffusionssperre bei der Wannentemperung und als Ätzstop beim Rückätzen des Polysilizium.

Das Verfahren nach der Erfindung bietet folgende Vorteile:
1. Die Implantation der zweiten Wanne und die Grabenätzung erfolgen selbstjustierend.
2. Es sind minimale n⁺/p⁺-Abstände und dadurch ein platzsparendes Design möglich.
3. Die Breite des Isolationsgrabens ist von der Auflösungsgrenze der Photomaskentechnik unabhängig.
4. Die Latch-up-Festigkeit wird erhöht. Durch eine entsprechende Wahl der Grabentiefe kann Latch-up völlig vermieden werden.
5. Da die Wannentemperung erst nach der Grabenätzung erfolgt, wird auch bei einer hohen Wannendotierung Segregation und gegenseitige Kompensation vermieden. Daher kann auf die Feldimplantation und die dafür notwendigen Phototechnik verzichtet werden.
6. Durch das Eintreiben der Wannen vor der vollständigen Auffüllung der Gräben werden mechanische Spannungen vermieden.
7. Durch die Verwendung von Polysilizium für die Grabenfüllung kann auch im Bereich der Isolationsgräben nachträglich ein Feldoxid erzeugt werden. Dadurch läßt sich das Verfahren leicht in den Gesamtprozeß einfügen.

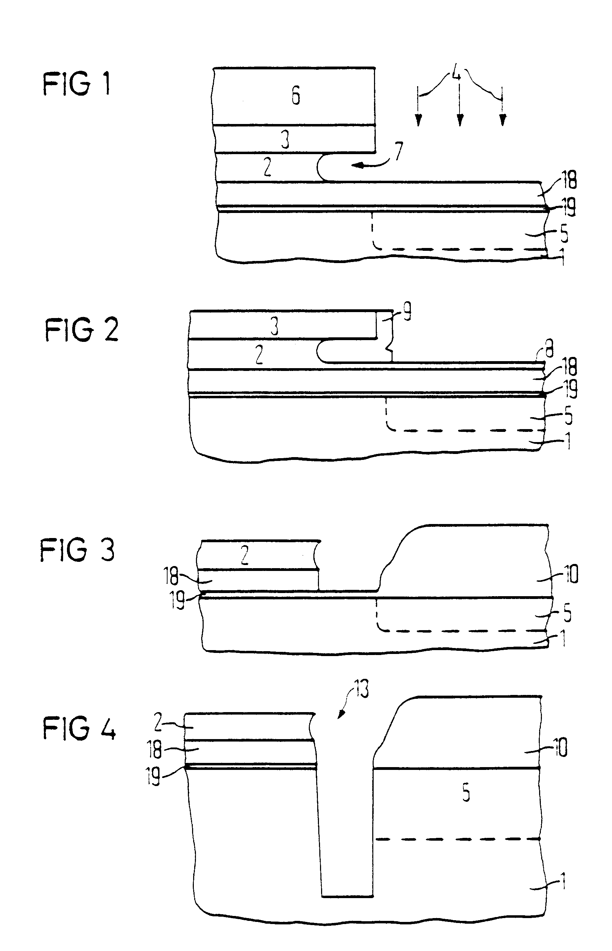

Weitere Einzelheiten der Erfindung werden anhand eines Ausführungsbeispiels und der Figuren 1 bis 7 noch näher beschrieben. Dabei zeigen
- die Figuren 1 bis 7: die erfindungswesentlichen Verfahrensschritte zur Herstellung eines Isolationsgrabens, bei denen eine Hilfsschicht aus Polysilizium verwendet wird.

Gleiche Teile sind in allen Figuren mit gleichen Bezugszeichen versehen.

Figur 1: Zu Beginn der n-Wannen-Prozeßfolge wird eine thermische Oxidation (30 nm) durchgeführt. Nach der thermischen Oxidation wird ganzflächig eine aus polykristallinem Silizium bestehende Hilfsschicht 18 in einer Schichtdicke von 200 nm durch thermische Zersetzung einer siliziumhaltigen gasförmigen Verbindung aufgebracht. Die durch thermische Oxidation der Oberfläche erzeugte SiO₂-Schicht (30 nm) ist mit dem Bezugszeichen 19 bezeichnet. Auf die Oberfläche der Hilfsschicht 18 wird eine erste Oxidschicht 2 durch thermische Zersetzung von Tetraethylorthosilikat (TEOS) in einer Schichtdicke von 200 bis 300 nm niedergeschlagen. Darauf wird aus der Gasphase eine erste Siliziumnitridschicht 3 in einer Schichtdicke im Bereich von 150 bis 250 nm aufgebracht. Die Implantation (siehe Pfeile 4) der n-Wanne 5 mit Phosphorionen mit einer Dosis und Energie von 1 x 10¹² cm⁻² und 180 keV erfolgt nach der Maskierung der späteren p-Wannengebiete (12) durch die Strukturierung der Doppelschicht: Siliziumnitrid 3/Oxidschicht 2 mit einer Photolackmaske 6. Die n-Wannengebiete 5 werden durch einen anisotropen Ätzprozeß freigeätzt. Nun erfolgt der Schritt der isotropen Unterätzung (siehe Pfeil 7) der ersten SiO₂-Schicht 2. Durch die naßchemische Unterätzung (7) der SiO₂-Schicht 2 wird die Lage des Isolationsgrabens (13) entlang der Wannenkante der p-Wanne (12) definiert. Die Grabenbrei- te ist über die Ätzzeit einstellbar.

Figur 2: Nach Entfernung der Photolackmaske 6 wird eine thermische Oxidation durchgeführt, wobei eine zweite Siliziumoxidschicht 8 als Zwischenoxid (30 nm) erzeugt wird. Dann wird eine zweite Siliziumnitridschicht 9 (im Bereich von 100 bis 200 nm) aus der Gasphase aufgebracht und durch einen anisotropen Rückätzprozeß so strukturiert, daß nur der Grabenbereich einschließlich der Unterätzung 7 bedeckt bleiben.

Mit Hilfe der Nitridschichten 3, 9 als Oxidationsmaske wird eine dritte Siliziumoxidschicht 10 (im Bereich von 600 bis 800 nm) durch thermische Oxidation erzeugt, welche zur Maskierung der n-Wannengebiete 5 bei der späteren p-Wannenimplantation (12) verwendet wird.

Figur 3: Nach erfolgter thermischer Oxidation, wobei aus der freiliegenden Polysiliziumschicht 18 die dritte Siliziumoxidschicht 10 (600 nm) entsteht, wird die Nitridmaske 3, 9 entfernt und die zweite, als Zwischenoxid dienende Siliziumoxidschicht 8 und das Polysilizium 18 im Grabenbereich anisotrop geätzt.

Figur 4: Nach Entfernung der Siliziumoxidschicht 19 im Bereich des Isolationsgrabens 13 erfolgt nun die Graben-ätzung (Breite 1 µm, Tiefe 2 bis 3 µm) durch einen anisotropen Ätzprozeß, wobei die Oxidschichten 2 und 10 als Ätzmaske dienen.

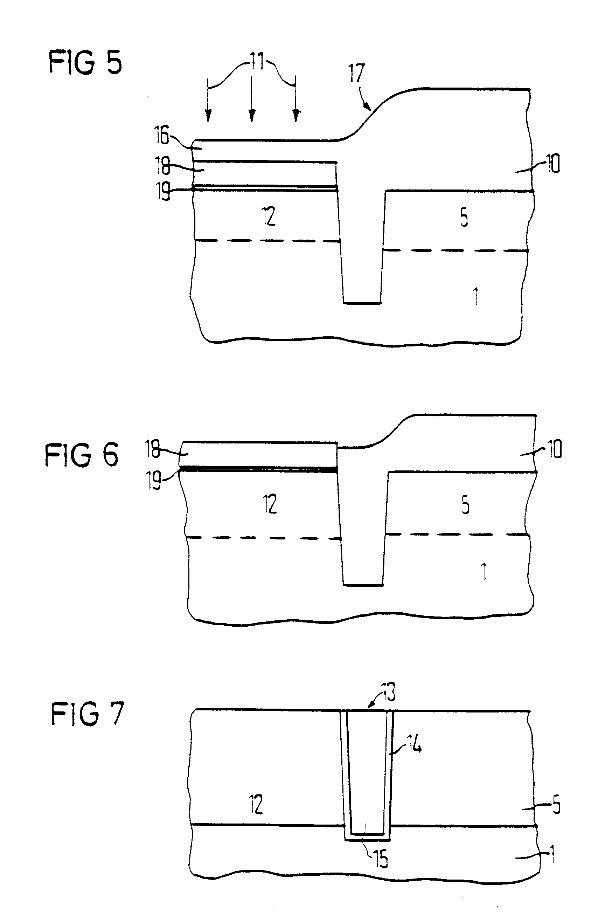

Figur 5: Auf der Oberfläche der in Fig. 4 dargestellten Struktur wird das als Streuoxid dienende SiO₂ durch Abscheiden und Rückätzen einer TEOS (= Tetraethylorthosilikat)- Schicht 16 gebildet. Dieses Oxid 16 dient gleichzeitig zur Maskierung des Bodens des Grabens 13 bei der nachfolgenden Borionenimplantation 11 zur Erzeugung der p-Wanne 12 (1 x 10¹³ Bor cm⁻², 180 keV). Außerdem wird das Maskieroxid 16 auf der n-Wanne 5 entlang der Wannenkante (s. Pfeil 17) verdickt, wodurch eine mögliche Kompensation der n-Wanne 5 in diesem Bereich verhindert wird.

Figur 6 zeigt die Anordnung nach dem Rückätzen der Oxidschicht 16.

Figur 7: Dann werden die restliche Polysiliziumschicht 18 und die Oxidschicht 10 und 19 naßchemisch entfernt. Der Graben 13 wird mit thermischem Oxid 14 (200 nm, vierte Siliziumoxidschicht) bedeckt. Nach einer Temperaturbehandlung für den Wannen-drive-in (1150 °C) wird der Graben 13, 14 mit polykristallinem Silizium 15 (500 nm) aufgefüllt. Dabei wird das Polysilizium 15 anisotrop zurückgeätzt und das restliche thermische Oxid 14 außerhalb des Grabens 13 auf naßchemischem Wege entfernt. Der weitere Prozeßverlauf folgt einer konventionellen Technologie.

Durch die Verwendung der Polysiliziumhilfsschicht 18 wird sichergestellt, daß die thermische Oxidation (10) bei der Maskierung der n-Wanne 5 nicht zur Ausbildung einer Stufe im Siliziumsubstrat führt. Eine solche Stufe würde bei späteren Photolacktechniken zu Fokusproblemen führen. Die Ausbildung einer solchen Stufe wird durch die Verwendung der Polysiliziumhilfsschicht 18 unter der ersten Siliziumoxid-/ ersten Siliziumnitridschicht 2, 3 wirksam vermieden, da bei der thermischen Oxidation diese Polysiliziumschicht 18 zu SiO₂ reagiert wird.

## Patentansprüche

1. Verfahren zum Herstellen von benachbarten, mit Dotierstoffen unterschiedlichen Leitungstyps implantierten Wannen, bei dem die Wannen in einem gemeinsamen Halbleitersubstrat angeordnet sind und bei dem die Wannen durch in das Substrat eingebrachte Isolationsgräben getrennt sind,
**gekennzeichnet durch**
folgende Schritte:
a) auf dem Substrat (1) wird eine SiO₂-Schicht (19) und darauf eine Hilfsschicht (18) aus polykristallinem Silizium erzeugt,
b) auf der Hilfsschicht (18) wird eine erste Siliziumoxidschicht (2) erzeugt,
c) auf der ersten Siliziumoxidschicht (2) wird eine erste Siliziumnitridschicht (3) erzeugt,
d) die erste Siliziumnitridschicht (3) und die erste Siliziumoxidschicht (2) werden so strukturiert, daß die oberhalb eines Bereichs einer zuerst zu implantierenden, ersten Wanne (5) befindlichen Anteile der ersten Siliziumoxidschicht (2) und der ersten Siliziumnitridschicht (3) entfernt werden,
e) unter Verwendung der ersten Siliziumoxidschicht (2) und der ersten Siliziumnitridschicht (3) als Implantationsmaske wird die erste Wanne (5) durch Implantation erzeugt,
f) die erste Siliziumoxidschicht (2) wird isotrop geätzt, so daß unter der ersten Siliziumnitridschicht (3) eine Unterätzung (7) gebildet wird,
g) durch Abscheiden und anisotropes Rückätzen einer zweiten Siliziumnitridschicht (9) wird die Unterätzung (7) mit der zweiten Siliziumnitridschicht (9) aufgefüllt,
h) durch thermische Oxidation der von der ersten Siliziumnitridschicht (3) und der zweiten Siliziumnitridschicht (9) unbedeckten Oberfläche wird eine zweite Siliziumoxidschicht (10) erzeugt, die als Implantationsmaske bei der Herstellung einer zweiten Wanne (12) durch Implantation verwendet wird,
i) unter Verwendung der ersten Siliziumoxidschicht (2) und der zweiten Siliziumoxidschicht (10) als Ätzmaske wird ein Isolatonsgraben (13) durch anisotrope Ätzung erzeugt, wobei die Grabentiefe über die Ätzzeit der anisotropen Ätzung eingestellt wird.

2. Verfahren nach Anspruch 1,
**dadurch gekennzeichnet,**
daß die Grabentiefätzung vor der Implantation (11) der zweiten Wanne (12) durchgeführt wird.

3. Verfahren nach einem der Ansprüche 1 oder 2,
**dadurch gekennzeichnet,**
daß nach der anisotropen Grabenätzung eine thermische Oxidation (14) durchgeführt wird, bei der auch die in die Wannen (5, 12) implantierten Dotierstoffionen eindiffundiert werden.

4. Verfahren nach einem der Ansprüche 1 bis 3,
**dadurch gekennzeichnet,**
daß die unter der Siliziumnitridschicht (3) liegende isotrop zu unterätzende Siliziumoxidschicht (2) durch thermische Zersetzung von Tetraethylorthosilikat (TEOS) erzeugt wird.

5. Verfahren zur Durchführung eines Doppelwannen-CMOS-Prozesses nach einem der Ansprüche 1 bis 4,
**gekennzeichnet durch**
den Ablauf der folgenden Verfahrensschritte:
a) thermische Oxidation einer Siliziumsubstratoberfläche (1),
b) ganzflächiges Aufbringen einer Hilfsschicht (18) aus polykristallinem Silizium,
c) Aufbringen einer ersten Siliziumoxidschicht (2) aus der Gasphase,
d) Aufbringen einer ersten Siliziumnitridschicht (3) aus der Gasphase,
e) Aufbringen einer Photolackstruktur (6), die die späteren p-Wannengebiete (12) im Substrat (1) maskiert,
f) anisotrope Ätzung der ersten Siliziumoxid/Siliziumnitridschicht (2, 3) zur Freilegung der n-Wannengebiete (5),
g) Durchführung einer Arsen-, Antimon- oder Phosphor-Ionen-Implantation (4) zur Erzeugung der n-Wannen (5),
h) Durchführung einer isotropen Unterätzung (7) der ersten Siliziumoxidschicht (2) zur Definition der Lage des Isolationsgrabens (13),
i) Entfernen der Photolackmaske (6),
j) Herstellen einer zweiten Siliziumoxidschicht (8) als Zwischenoxid durch thermische Oxidation,
k) Abscheiden einer zweiten Siliziumnitridschicht (9) und anisotrope Rückätzung dieser Siliziumnitridschicht (9) so, daß im Bereich der Unterätzung (7) der ersten Siliziumoxidschicht (2) die zweite Siliziumnitridschicht (9) verbleibt,
l) Herstellen einer dritten Siliziumoxidschicht (10) durch thermische Oxidation der Hilfsschicht (18) aus Polysilizium,
m) Entfernung der ersten und zweiten Siliziumnitridschicht (3, 9),
n) Entfernung der zweiten, als Zwischenoxid dienenden Siliziumoxidschicht (8) und der Hilfsschicht (18) aus Polysilizium im Bereich der Isolationsgräben (13) durch anisotrope Ätzung,
o) Durchführung der Grabenätzung durch anisotropes Ätzen,
p) Aufbringen einer weiteren Siliziumoxidschicht (16), die auf die Dicke einer Implantationsmaske zurückgeätzt wird,
q) Durchführung einer Bor-Ionen-Implantation (11) zur Erzeugung der p-Wanne (12),
r) Entfernung der ersten und dritten Siliziumoxidschicht (2, 10) sowie der Hilfsschicht (18) und der darunterliegenden Siliziumoxidschicht (19),
s) Erzeugung einer vierten Siliziumoxidschicht (14) durch thermische Oxidation,
t) Durchführung einer Temperaturbehandlung zur Eindiffusion der in die Wannen (5, 12) implantierten Dotierstoffatome und
u) Auffüllung der Gräben (13, 14) mit polykristallinem Silizium (15) aus der Gasphase, anisotrope Rückätzung des polykristallinen Silizium (15) und naßchemische Rückätzung der auf der Substratoberfläche verbliebenen vierten Siliziumoxidschicht (14) in bekannter Weise.

6. Verfahren nach Anspruch 5,
**dadurch gekennzeichnet,**
daß die Dicke der ersten Siliziumoxidschicht (2) auf 200 bis 300 nm, die der ersten Siliziumnitridschicht (3) auf 150 bis 250 nm, die der zweiten Siliziumnitridschicht (9) auf 100 bis 200 nm, die der zweiten Siliziumoxidschicht (8) auf 30 bis 50 nm und die der dritten Silizumoxidschicht (10) auf 600 bis 800 nm eingestellt wird.

7. Verfahren nach Anspruch 5 oder 6,
**dadurch gekennzeichnet,**
daß die Schichtdicke der aus polykristallinem Silizium bestehenden Hilfsschicht (18) auf 200 nm eingestellt wird.

8. Verfahren nach einem der Ansprüche 1 bis 7,
**dadurch gekennzeichnet,**
daß zur Erzeugung der n-Wanne eine Phosphor-Ionen-Implantation mit einer Energie und Dosis von 2 x 10¹² cm⁻² und 180 keV und zur Erzeugung der p-Wanne eine Bor-Ionen-Implantation mit einer Energie und Dosis von 1 x 10¹³ cm⁻² und 180 keV durchgeführt wird.

9. Verfahren nach einem der Ansprüche 1 bis 8,
**dadurch gekennzeichnet,**
daß der Graben (13) bei einer Breite von 1 µm bis zu einer Tiefe von 2 bis 3 µm geätzt wird.

10. Verfahren nach einem der Ansprüche 1 bis 9,
**dadurch gekennzeichnet,**
daß die isotrope Ätzung (7) der unter der Siliziumnitridschicht (3) liegenden Siliziumoxidschicht (2) auf naßchemischem Wege erfolgt.

## Claims

1. A method for manufacturing adjacent wells into which dopants of different type of conductivity have been implanted, in which method the wells are arranged in a common semiconductor substrate and in which the wells are separated by insulation trenches formed in the substrate, characterised by the following steps:
a) on the substrate (1), an SiO₂ layer (19) and on this an auxiliary layer (18) of polycrystalline silicon is generated,
b) on the auxiliary layer (18), a first silicon oxide layer (2) is generated,
c) on the first silicon oxide layer (2), a first silicon nitride layer (3) is generated,
d) the first silicon nitride layer (3) and the first silicon oxide layer (2) are patterned in such a manner that the proportions of the first silicon oxide layer (2) and of the first silicon nitride layer (3) located above an area of a first well (5) first to be doped are removed,
e) the first well (5) is generated by implantation, using the first silicon oxide layer (2) and the first silicon nitride layer (3) as implantation mask,
f) the first silicon oxide layer (2) is isotropically etched so that an underetching (7) is formed under the first silicon nitride layer (3),
g) the underetching (7) is filled up with the second silicon nitride layer (9) by precipitating a second silicon nitride layer (9) and anisotropically etching it back,
h) a second silicon oxide layer (10), which is used as implantation mask during the fabrication of a second well (12) by implantation, is generated by thermal oxidation of the surface not covered by the first silicon nitride layer (3) and the second silicon nitride layer (9),
i) using the first silicon oxide layer (2) and the second silicon oxide layer (10) as etching mask, an insulation trench (13) is generated by anisotropic etching, the trench depth being set by means of the etching time of the anisotropic etching.

2. Method according to Claim 1, characterised in that the trench deep etching is carried out before the implantation (11) of the second well (12).

3. Method according to one of Claims 1 or 2, characterised in that, after the anisotropic trench etching, a thermal oxidation (14) is carried out in which the dopant ions implanted in the wells (5, 12) are also difused in.

4. Method according to one of Claims 1 to 3, characterised in that the silicon oxide layer (2) to be isotropically underetched and located underneath the silicon nitride layer (3) is generated by thermal decomposition of the tetraethylorthosilicate (TEOS).

5. Method for carrying out a dual-well CMOS process according to one of Claims 1 to 4, characterised by the sequence of the following method steps:
a) thermal oxidation of a silicon substrate surface (1),
b) whole-area application of an auxiliary layer (18) of polycrystalline silicon,
c) application of a first silicon oxide layer (2) from the gas phase,
d) application of a first silicon nitride layer (3) from the gas phase,
e) application of a photoresist pattern (6) which masks the later p-type well areas (12) in the substrate (1),
f) anisotropic etching of the first silicon oxide/silicon nitride layer (2, 3) for exposing the n-type well areas (5),
g) carrying out an arsenic, antimony or phosphorus ion implantation (4) for generating the n-type wells (5),
h) carrying out an isotropic underetching (7) of the first silicon oxide layer (2) to define the position of the insulation trench (13),
i) removal of the photoresist mask (6),
j) production of a second silicon oxide layer (8) as intermediate oxide by thermal oxidation,
k) precipitating a second silicon nitride layer (9) and anisotropic backetching of this silicon nitride layer (9) in such a manner that the second silicon nitride layer (9) remains in the area of the underetching (7) of the first silicon oxide layer (2),
l) production of a third silicon oxide layer (10) by thermal oxidation of the auxiliary layer (18) of polysilicon,
m) removal of the first and second silicon nitride layer (3, 9),
n) removal of the second silicon oxide layer (8) used as intermediate oxide and of the auxiliary layer (18) of polysilicon in the area of the insulation trenches (13) by anisotropic etching,
o) carrying out the trench etching by anisotropic etching,
p) application of a further silicon oxide layer (16) which is etched back to the thickness of an implantation mask,
q) carrying out a boron ion implantation (11) to generate the p-type well (12),
r) removal of the first and third silicon oxide layer (2, 10) and of the auxiliary layer (18) and of the underlying silicon oxide layer (19),
s) generating a fourth silicon oxide layer (14) by thermal oxidation,
t) carrying out a temperature treatment to defuse in the dopant atoms implanted in the wells (5, 12), and
u) filling up the trenches (13, 14) with polycrystalline silicon (15) from the gas phase, anisotropic backetching of the polycrystalline silicon (15) and wet chemical backetching of the fourth silicon oxide layer (14) remaining on the substrate surface, in familiar manner.

6. Method according to Claim 5, characterised in that the thickness of the first silicon oxide layer (2) is set to 200 to 300 nm, that of the first silicon nitride layer (3) is set to 150 to 250 nm, that of the second silicon nitride layer (9) is set to 100 to 200 nm, that of the second silicon oxide layer (8) is set to 30 to 50 nm and that of the third silicon oxide layer (10) is set to 600 to 800 nm.

7. Method according to Claim 5 or 6, characterised in that the layer thickness of the auxiliary layer (18) consisting of polycrystalline silicon is set to 200 nm.

8. Method according to one of Claims 1 to 7, characterised in that a phosphorus ion implantation is carried out with an energy and dose rate of 2 x 10¹² cm⁻² and 180 keV for generating the n-type well and a boron ion implantation is carried out with an energy and dose rate of 1 x 10¹³ cm⁻² and 180 keV for generating the p-type well.

9. Method according to one of Claims 1 to 8, characterised in that the trench (13) is etched down to a depth of 2 to 3 µm with a width of 1 µm.

10. Method according to one of Claims 1 to 9, characterised in that the isotropic etching (7) of the silicon oxide layer (2) located below the silicon nitride layer (3) is effected by wet chemical means.

## Revendications

1. Procédé pour fabriquer des cuvettes voisines, dans lesquelles sont implantées des substances dopantes de conductions de type différent, selon lequel les cuvettes sont disposées dans un substrat semiconducteur commun et sont séparées par des sillons d'isolation ménagés dans le substrat, caractérisé par les étapes suivantes :
a) sur le substrat (1), on produit une couche de SiO₂ (19), sur laquelle on produit une couche auxiliaire (18) en silicium polycristallin,
b) sur la couche auxiliaire (18), on produit une première couche d'oxyde de silicium (2),
c) sur la première couche d'oxyde de silicium (2), on produit une première couche de nitrure de silicium (3),
d) on structure la première couche de nitrure de silicium (3) et la première couche d'oxyde de silicium (2) de manière à éliminer les parties, situées au-dessus d'une zone d'une première cuvette (5), qui doit être implantée en premier, de la première couche d'oxyde de silicium (2) et de la première couche de nitrure de silicium (3),
e) en utilisant la première couche d'oxyde de silicium (2) et la première couche de nitrure de silicium (3) comme masque d'implantation, on produit par implantation la première cuvette (5),
f) on élimine par une corrosion isotrope la première couche d'oxyde de silicium (2) de manière à former une partie corrodée sous-jacente (7) en-dessous de la première couche de nitrure de silicium (3),
g) par dépôt et rétrocorrosion anisotrope d'une deuxième couche de nitrure de silicium (9), on remplit la partie corrodée sous-jacente (7) de la deuxième couche de nitrure de silicium (9),
h) par oxydation thermique de la surface non recouverte par la première couche de nitrure de silicium (3) et par la deuxième couche de nitrure de silicium (9), on produit une deuxième couche d'oxyde de silicium (10), qu'on utilise comme masque d'implantation lors de la fabrication d'une seconde cuvette (12) par implantation,
i) en utilisant la première couche d'oxyde de silicium (2) et la deuxième couche d'oxyde de silicium (10) comme masque de corrosion, on produit un sillon d'isolation (13) par corrosion anisotrope, la profondeur du sillon étant réglée en fonction de la durée de la corrosion anisotrope.

2. Procédé suivant la revendication 1, caractérisé par le fait qu'on effectue la corrosion en profondeur du sillon avant l'implantation (11) de la seconde cuvette (12).

3. Procédé suivant l'une des revendications 1 ou 2, caractérisé par le fait qu'après la corrosion anisotrope du sillon, on effectue une oxydation thermique (14), par laquelle les ions de substance dopante implantés dans les cuvettes (5,12) diffusent également.

4. Procédé suivant l'une des revendications 1 à 3, caractérisé par le fait qu'on produit la couche d'oxyde de silicium (2) qui est sous-jacente à la couche de nitrure de silicum (3) et qui doit être soumise à une corrosion sous-jacente anisotrope, par décomposition thermique d'orthosilicate de tétraéthyle (TEOS).

5. Procédé pour la mise en oeuvre d'un procédé CMOS à deux cuvettes suivant l'une des revendications 1 à 4, caractérisé par l'exécution des étapes opératoires suivantes :
a) oxydation thermique d'une surface (1) d'un substrat en silicium,
b) dépôt, sur toute la surface, d'une couche auxiliaire (18) en silicium polycristallin,
c) dépôt en phase gazeuse d'une première couche d'oxyde de silicium (2),
d) dépôt en phase gazeuse d'une première couche de nitrure de silicium (3),
e) dépôt d'une structure de vernis photosensible (6), qui masque les régions de cuvette de type p (12) ultérieures du substrat (1),
f) corrosion anisotrope des premières couches d'oxyde de silicium/nitrure de silicium (2,3) pour mettre à nu les régions de cuvette de type n (5),
g) exécution d'une implantation (4) d'ions d'arsenic, d'antimoine ou de phosphore pour produire des cuvettes de type n (5),
h) corrosion sous-jacente isotrope (7) de la première couche d'oxyde de silicium (2) pour définir la position du sillon d'isolation (13),
i) élimination du masque de vernis photosensible (6),
j) fabrication d'une deuxième couche d'oxyde de silicium (8) en tant qu'oxyde intermédiane par oxydation thermique,
k) dépôt d'une seconde couche de nitrure de silicium (9) et rétrocorrosion anisotrope de cette couche de nitrure de silicium (9) de sorte que la deuxième couche de nitrure de silicium (9) subsiste dans la partie corrodée sous-jacente (7) de la première couche d'oxyde de silicium (2),
l) fabrication d'une troisième couche d'oxyde de silicium (10) par oxydation thermique de la couche auxiliaire (18) en polysilicium,
m) élimination des première et deuxième couches de nitrure de silicium (3,9),
n) élimination de la deuxième couche d'oxyde de silicium (8) utilisée comme oxyde intermédiane et de la couche auxiliaire (18) de polysilicium dans la zone des sillons d'isolation (13), par corrosion anisotrope,
o) formation des sillons par corrosion anisotrope,
p) dépôt d'une autre couche d'oxyde de silicium (16), que l'on soumet à une rétrocorrosion jusqu'à ce qu'elle possède l'épaisseur d'un masque d'implantation,
q) implantation d'ions de bore (11) pour produire la cuvette de type p (12),
r) élimination des première et troisième couches d'oxyde de silicium (2,10) ainsi que de la couche auxiliaire (18) et de la couche d'oxyde de silicium sous-jacente (19),
s) production d'une quatrième couche d'oxyde de silicium (14) par oxydation thermique,
t) traitement thermique pour faire diffuser les atomes de substance dopante implantés dans les cuvettes (5,12), et
u) remplissage en phase gazeuse des sillons (13,14) par du silicium polycristallin (15), rétrocorrosion anisotrope du silicium polycristallin (15) et rétrocorrosion par voie humide de la quatrième couche d'oxyde de silicium (14), qui subsiste sur la surface du substrat, d'une manière connue.

6. Procédé suivant la revendication 5, caractérisé par le fait qu'on règle l'épaisseur de la première couche d'oxyde de silicium (2) entre 200 et 300 nm, l'épaisseur de la première couche de nitrure de silicium (3) entre 150 et 250 nm, l'épaisseur de la deuxième couche de nitrure de silicium (9) entre 100 et 200 nm, l'épaisseur de la deuxième couche d'oxyde de silicium (8) entre 30 et 50 nm et l'épaisseur de la troisième couche d'oxyde de silicium (10) entre 600 et 800 nm.

7. Procédé suivant la revendication 5 ou 6, caractérisé par le fait qu'on règle l'épaisseur de la couche auxiliaire (18) en silicium polycristallin, à 200 nm.

8. Procédé suivant l'une des revendications 1 à 7, caractérisé par le fait que pour produire la cuvette de type n, on effectue une implantation d'ions phosphore avec une dose de 2 x 10¹² cm⁻² et une énergie de 180 keV et que pour la formation de la cuvette de type p, on effectue une implantation d'ions bore avec une dose de 1 x 10¹³ cm⁻² et une énergie de 180 kev.

9. Procédé suivant l'une des revendications 1 à 8, caractérisé par le fait qu'on forme par corrosion le sillon (13) sur une largeur de 1 µm jusqu'à une profondeur de 2 à 3 µm.

10. Procédé suivant l'une des revendications 1 à 9, caractérisé par le fait que la corrosion isotrope (7) de la couche d'oxyde de silicium (2) en-dessous de la couche de nitrure de silicium (3) s'effectue par voie chimique humide.
